# EUROPÄISCHE PATENTANMELDUNG

(11) **EP 4 707 790 A1**
(43) Veröffentlichungstag der Anmeldung: **11.03.2026**
(21) Anmeldenummer: 24198827.8
(22) Anmeldetag: 06.09.2024
(51) Int. Cl.: G01N 24/10, G01R 33/24, G01R 33/36, G01R 33/60, G01R 33/30

(54) **VERFAHREN ZUR ERZEUGUNG UND/ODER DETEKTION EINER MAGNETISIERUNG, MAGNETOMETER UND SPEKTROSKOPIEVORRICHTUNG**

(71) Anmelder: Universität Stuttgart, 70174 Stuttgart (DE)
(72) Erfinder: Anders, Jens, 70174 Stuttgart (DE); Khan, Muhammad Khubaib Ul Hassan, 70174 Stuttgart (DE)
(74) Vertreter: Lorenz & Kollegen

(57) **Zusammenfassung**

Die Erfindung betrifft ein Verfahren zur Erzeugung und/oder Detektion einer Magnetisierung einer Probe (2) an einem Probenort (3), insbesondere für die Untersuchung der Probe (2) mittels Elektronenspinresonanz-Spektroskopie oder für die Messung eines auf die Probe (2) an dem Probenort (3) einwirkenden ersten Magnetfeldes (B₀). Eine induktive Baugruppe (5) wird durch ein Anregungssignal (S) angeregt, um ein zweites Magnetfeld (B₁) an dem Probenort (3) bereitzustellen, wobei das Anregungssignal (S) zyklisch zwischen einem Anregungszeitraum (TX), in dem eine Betriebsfrequenz (f_{ESR}) des Anregungssignals (S) eine probenspezifische Resonanzfrequenz (fᵣₑₛ) aufweist, und einem Leerlaufzeitraum (RX), in dem die Betriebsfrequenz (f_{ESR}) des Anregungssignals (S) eine von der Resonanzfrequenz (fᵣₑₛ) verschiedene Leerlauffrequenz (f_{idle}) aufweist, umgeschaltet wird. Es ist vorgesehen, dass eine Betriebsphase des Anregungssignals (S) zumindest im Rahmen des Umschaltens der Betriebsfrequenz (f_{ESR}) von der Leerlauffrequenz (f_{idle}) in die Resonanzfrequenz (fᵣₑₛ) an eine Anregungsreferenzphase eines von dem Anregungssignal (S) separaten, vorzugsweise kontinuierlich erzeugten, Anregungsreferenzsignals (S_{ref}) angeglichen wird.

## Beschreibung

Die Erfindung betrifft ein Verfahren zur Erzeugung und/oder Detektion einer Magnetisierung einer Probe an einem Probenort, insbesondere für die Untersuchung der Probe mittels Elektronenspinresonanz-Spektroskopie oder für die Messung eines auf die Probe an dem Probenort einwirkenden ersten Magnetfeldes, gemäß dem Oberbegriff des Anspruchs 1.

Die Erfindung betrifft ferner ein Magnetometer zur Messung eines ersten Magnetfeldes durch Erzeugung und/oder Detektion einer Magnetisierung einer Probe an einem Probenort, insbesondere ein kernspinresonanzbasiertes Magnetometer oder ein elektronenspinresonanzbasiertes Magnetometer, aufweisend eine induktive Baugruppe und eine Steuereinrichtung, gemäß dem Oberbegriff des Anspruchs 13.

Die Erfindung betrifft außerdem eine Spektroskopievorrichtung zur Untersuchung einer Probe an einem Probenort, insbesondere eine Elektronenspinresonanz-Spektroskopievorrichtung oder eine Kernspinresonanz-Spektroskopievorrichtung, aufweisend eine Einrichtung zur Erzeugung eines ersten Magnetfeldes an dem Probenort, eine induktive Baugruppe und eine Steuereinrichtung, gemäß dem Oberbegriff des Anspruchs 15.

Magnetfeldsensoren bzw. Magnetometer finden sich in vielen technologischen Anwendungen. Sie erfassen und messen magnetische Felder und ermöglichen es, Informationen über die magnetische Umgebung zu gewinnen.

Unter anderem in der Medizintechnik spielen Magnetfeldsensoren eine wichtige Rolle, wo sie beispielsweise in der Magnetresonanztomographie (MRT) verwendet werden, um das für die Bildgebung vorgesehene Magnetfeld hochgenau zu vermessen, Inhomogenitäten dieses Magnetfeldes zu bestimmen, anschließend auszugleichen und somit detaillierte Bilder des Körperinneren zu erstellen.

Auch in der Elektronenspinresonanz-Spektroskopie (ESR), mitunter auch als EPR ("Electron Paramagnetic Resonance Spectroscopy") bezeichnet, die u. a. zur Messung von Radikalen in Lebensmitteln und medizinisch relevanten Proben (z. B. Blutproben, aber auch Medikamenten) verwendet wird, finden Magnetfeldsensoren Anwendung. Bei der Elektronenspinresonanz-Spektroskopie werden die Proben in einem statisch homogenen, statisch inhomogenen oder dynamischen (gepulst inhomogenen) Magnetfeld, üblicherweise als B₀ bezeichnet (nachfolgend: "erstes Magnetfeld"), zusätzlichen hochfrequenten, elektromagnetischen Wechselfeldern, üblicherweise als B₁ bezeichnet (nachfolgend: "zweites Magnetfeld"), ausgesetzt. Durch die Einkopplung dieser zusätzlichen Wechselfelder werden Übergänge zwischen den Energieniveaus diskreter Spinzustände der Atomkerne (NMR) und/oder Elektronen (ESR, DNP, ENDOR) einer Probe induziert, die ihrerseits zu Absorptionsvorgängen im Wechselfeld führen, welche sich detektieren lassen. Aus den detektierten Absorptionsvorgängen lassen sich verschiedene stoffanalytische Informationen der Probe bestimmen. Die Elektronenspinresonanz-Spektroskopie ist somit ein leistungsfähiges Verfahren, das den Spin eines ungepaarten Elektrons als nanoskopische Sonde im Inneren eines Moleküls nutzt, um über kleine Änderungen der Resonanzfrequenz Informationen über die chemische Struktur und Zusammensetzung der Probe zu gewinnen. Die Proben können sowohl flüssig, fest oder auch gasförmig sein. Insbesondere bei der Untersuchung von Reaktionskinetik oder Abläufen/Veränderungen in biologischen oder chemischen Prozessen wird eine besonders schnelle und hochpräzise Magnetfeldmessung und -regelung benötigt, da bereits Schwankungen über kurze Zeitabstände einen direkten Einfluss auf die Qualität der Messergebnisse haben können.

Ein ähnliches Verfahren ist die Kernspinresonanz-Spektroskopie (NMR, "Nuclear Magnetic Resonance Spectroscopy"), die sich auf Proben mit Atomkernen mit "Nettokernspin" aufgrund einer ungeraden Anzahl an Nukleonen anwenden lässt.

Zum weiteren technologischen Hintergrund zu ESR und NMR sei an dieser Stelle beispielhaft auf die DE 10 2016 102 025 A1 verwiesen.

In den letzten Jahren sind verschiedene Konzepte für oszillatorbasierte CMOS-integrierte ESR-Detektoren ("EPR/ESR-on-a-chip") für verschiedene Grundfrequenzen bis 146 GHz bekannt geworden. Zum Beispiel wurden spannungsgesteuerte Oszillatoren (VCOs) als Elektronenspinresonanz (ESR)-Sensoren in der Veröffentlichung von Handwerker, J. et al. "A 14 GHz batteryoperated point-of-care ESR spectrometer based on a 0.13 µm CMOS ASIC", IEEE International Solid-State Circuits Conference (ISSCC), pp. 476-477 im Jahr 2016 vorgeschlagen.

Insbesondere durch die Verwendung spannungsgesteuerter LC-Oszillatoren zur Erzeugung des zweiten Magnetfeldes B₁, können insgesamt kompaktere, kostengünstigere und dennoch leistungsstarke Systeme bereitgestellt werden. Entsprechende, VCO-basierte B₁-Quellen bieten zwar viele Vorteile, darunter die Möglichkeit, die Spin-Magnetisierung bereits während der Anregungspulse induktiv zu erfassen, leiden aber unter der Tatsache, dass der begrenzte Qualitätsfaktor des eingebetteten LC-Resonators einen unteren Schwellenwert für den minimalen Oszillationsstrom im Inneren der Induktivität erfordert. Da die Tankinduktivität ("tank inductor") des VCO direkt mit dem Spin-Ensemble gekoppelt ist, ohne die Möglichkeit, das B₁-Feld nach Bedarf ein- und auszuschalten, erfordern VCO-basierte gepulste Anregungssignale das Umschalten der VCO-Betriebsfrequenz in und aus der probenspezifischen Resonanzfrequenz.

Das Umschalten der Betriebsfrequenz führt allerdings zu einem Verlust der Phaseninformation zwischen aufeinanderfolgenden Anregungsimpulsen bzw. Anregungszeiträumen. Durch den Kohärenzverlust wird die Auswertung des Antwortsignals der Probe erschwert bzw. die Messgenauigkeit deutlich verringert.

Zur Lösung des genannten Kohärenzproblems wird in der Veröffentlichung von M. Hassan et. al., "Towards single-cell pulsed EPR using VCO-based EPR-on-a-chip detectors", Frequenz, vol. 76, no. 11-12, pp. 699-717, Sept. 2022, ein Regelkreis vorgeschlagen, um die Phase des Anregungssignals zu korrigieren. Die vorgeschlagene Technik ist allerdings vergleichsweise aufwändig und es besteht zudem der Bedarf, die Messgenauigkeit noch weiter zu erhöhen. Denn die Phasenstabilisierung sollte vorzugsweise im Bereich von Pikosekunden erfolgen und die hierzu erforderliche Bandbreite in der Phasenregelungsschleife (PLL) ist technisch nicht ohne Weiteres zu erreichen. Die Verzögerung bei der Phasenanpassung kann daher weiterhin zu signifikanten Kohärenzverlusten führen, was wiederum die Genauigkeit und Empfindlichkeit der Messungen beeinträchtigt.

In Anbetracht des bekannten Standes der Technik besteht die Aufgabe der vorliegenden Erfindung darin, ein Verfahren zur Erzeugung und/oder Detektion einer Magnetisierung einer Probe bereitzustellen, mittels dem eine besonders hohe Messgenauigkeit erreichbar ist, vorzugsweise unter Verwendung gepulster, mittels eines spannungsgesteuerten Oszillators erzeugter Anregungssignale.

Der vorliegenden Erfindung liegt auch die Aufgabe zugrunde, ein Magnetometer bereitzustellen, mit dem eine besonders hohe Messgenauigkeit erreichbar ist, vorzugsweise unter Verwendung gepulster, mittels eines spannungsgesteuerten Oszillators erzeugter Anregungssignale.

Schließlich ist es auch Aufgabe der Erfindung, eine Spektroskopievorrichtung bereitzustellen, mit der eine besonders hohe Messgenauigkeit erreichbar ist, vorzugsweise unter Verwendung gepulster, mittels eines spannungsgesteuerten Oszillators erzeugter Anregungssignale.

Die Aufgabe wird für das Verfahren mit den in Anspruch 1 aufgeführten Merkmalen gelöst. Hinsichtlich des Magnetometers wird die Aufgabe durch die Merkmale des Anspruchs 13 und bezüglich der Spektroskopievorrichtung durch die Merkmale des Anspruchs 15 gelöst.

Die abhängigen Ansprüche und die nachfolgend beschriebenen Merkmale betreffen vorteilhafte Ausführungsformen und Varianten der Erfindung.

Es ist ein Verfahren zur Erzeugung und/oder Detektion einer Magnetisierung einer Probe an einem Probenort vorgesehen, bei dem eine induktive Baugruppe durch ein Anregungssignal angeregt wird, um ein zweites Magnetfeld an dem Probenort bereitzustellen.

Das erfindungsgemäße Verfahren eignet sich insbesondere vorteilhaft für eine spektroskopische Untersuchung der Probe (z. B. mittels Elektronenspinresonanz-Spektroskopie oder Kernspinresonanz-Spektroskopie) oder für die Messung eines auf die Probe an dem Probenort einwirkenden äußeren Magnetfeldes (nachfolgend als "erstes Magnetfeld" bezeichnet).

Erfindungsgemäß wird das Anregungssignal zyklisch zwischen einem Anregungszeitraum, in dem eine Betriebsfrequenz des Anregungssignals eine probenspezifische Resonanzfrequenz aufweist, und einem Leerlaufzeitraum, in dem die Betriebsfrequenz des Anregungssignals eine von der Resonanzfrequenz verschiedene Leerlauffrequenz aufweist, umgeschaltet.

Während des Anregungszeitraums des Anregungssignals kann somit ein "Anregungspuls" erzeugt werden, der durch den darauffolgenden Leerlaufzeitraum des Anregungssignals von dem anschließenden Anregungspuls zeitlich beabstandet ist. Unter einem "Anregungspuls" wird im Rahmen der vorliegenden Erfindung ein der induktiven Baugruppe zugeführtes elektrisches Signal verstanden, das sich funktional zur Erzeugung eines zweiten Magnetfeldes eignen kann. Insbesondere können die Anregungspulse eine ausreichend große Amplitude und eine geeignete Frequenz aufweisen, um die Magnetisierung der Probe ausgehend von ihrem Ausgangs- bzw. Gleichgewichtszustand auf geeignete Weise auszulenken.

Es kann vorgesehen sein, dass der zeitliche Abstand zwischen allen unmittelbar aufeinander folgenden Anregungspulsen identisch ist. Grundsätzlich kann allerdings auch vorgesehen sein, dass sich der zeitliche Abstand zwischen zumindest zwei aufeinander folgenden Anregungspulsen unterscheidet.

Vorzugsweise (aber nicht notwendigerweise) kann die induktive Baugruppe derart angeordnet und ausgerichtet sein, dass das zweite Magnetfeld an dem Probenort zumindest im Wesentlichen orthogonal zu dem ersten Magnetfeld ausgerichtet ist, da in der konventionellen ESR lediglich orthogonale Komponenten des zweiten Magnetfeldes eine entsprechende Auslenkung der Magnetisierung der Probe bewirken können. Das zweite Magnetfeld kann somit zumindest eine orthogonal zu dem ersten Magnetfeld ausgerichtete Komponente aufweisen.

Bei der induktiven Baugruppe kann es sich um eine induktive Baugruppe beliebiger Bauart handeln, die sich zur Bereitstellung des zweiten Magnetfeldes im Rahmen der vorstehend genannten Anwendungen vorteilhaft eignet. Insbesondere kann die induktive Baugruppe eines oder mehrere induktive Elemente aufweisen (z. B. "plattenförmige" bzw. planare, aus einem Metallwerkstoff gebildete induktive Elemente oder aus einem Spulendraht gebildete induktive Elemente).

Vorzugsweise ist der Probenort im Nahfeld der induktiven Baugruppe angeordnet. Der Probenort kann gegebenenfalls aber auch im Fernfeld der induktiven Baugruppe angeordnet sein.

Bei dem ersten Magnetfeld kann es sich vorzugsweise um ein statisches oder ein quasi-statisches Magnetfeld handeln.

Als Proben kommen feste, gasförmige und/oder flüssige Proben in Betracht. Flüssige Proben können z. B. in Glaskapillaren auf oder in Schaltungskomponenten befestigt werden (z. B. auch in CMOS-Technologie). Bei niedrigeren Frequenzen des ersten Magnetfeldes bis in das sogenannte X-Band (ca. 10 GHz) können die Spulen der induktiven Baugruppe gegebenenfalls auch als Volumenspulen realisiert werden, in die die Kapillaren mit flüssigen Proben eingebracht werden können. Das Verfahren (bzw. eine entsprechende Vorrichtung) kann gegebenenfalls auch innerhalb der zu messenden Flüssigkeit, dem Gas oder dem Festkörper ausgeführt werden, um beispielsweise Phasenübergänge und Übergänge von Aggregatzuständen zu erfassen.

An dieser Stelle sei erwähnt, dass im Rahmen der vorliegenden Erfindung grundsätzlich eine beliebige Anzahl von Anregungspulsen bzw. Anregungszeiträumen vorgesehen sein können, zumindest aber zwei aufeinander folgende Anregungspulse bzw. Anregungszeiträume. In der Regel kann eine Erhöhung der Anzahl Anregungspulse / Anregungszeiträume bzw. der Anzahl korrespondierender Messungen die Messgenauigkeit erhöhen. Es kann daher zwischen Messdauer und Präzision anwendungsbedingt abzuwägen sein.

Bei dem Anregungspuls bzw. dem Anregungssignal in dem Anregungszeitraum (und ggf. auch bei dem Anregungssignal in dem Leerlaufzeitraum) kann es sich vorzugsweise um ein periodisches Signal handeln, wie beispielsweise ein Sinussignal. Als Einhüllende bzw. Hüllkurve des Anregungssignals kann insbesondere ein Rechtecksignal vorgesehen sein, wobei aber auch andere Kurvenformen als Einhüllende in Frage kommen können, wie beispielsweise eine Gauß-Kurve. Auch das periodische Signal des Anregungssignals kann grundsätzlich beliebig sein und muss nicht unbedingt einem Sinus entsprechen. Insbesondere hat sich aber die Kombination eines Rechtecksignals als Einhüllende mit einem Sinussignal für die vorgesehenen Anwendungen als besonders geeignet herausgestellt, da dies die technisch einfachste Realisierung darstellt, die in der Regel auch ausreichend ist.

Die Pulsdauer der einzelnen Anregungspulse kann im Rahmen der vorliegenden Erfindung beliebig sein, vorzugsweise ist in dem Anregungspuls aber zumindest eine Periode des besagten periodischen Signals enthalten, vorzugsweise zumindest zwei, drei, beispielsweise vier, fünf oder noch mehr Perioden (grundsätzlich kann in dem Anregungspuls aber auch nur ein Bruchteil einer Periode des periodischen Signals enthalten sein).

Die Pulsdauer der aufeinander folgenden Anregungspulse kann vorzugsweise identisch sein. Grundsätzlich (je nach Experiment bzw. Anwendung) kann allerdings auch vorgesehen sein, dass sich die Pulsdauer zwischen zumindest zwei aufeinander folgenden Anregungspulsen unterscheidet. Die Verwendung phasenkohärenter Anregungspulse mit variablem Abstand kann beispielsweise zur Messung von Distanzen in Molekülen vorteilhaft sein (so genannte PELDOR- bzw. DEER-Spektroskopie).

Erfindungsgemäß ist vorgesehen, dass eine Betriebsphase des Anregungssignals zumindest im Rahmen des Umschaltens der Betriebsfrequenz von der Leerlauffrequenz in die Resonanzfrequenz an eine Anregungsreferenzphase eines von dem Anregungssignal separaten Anregungsreferenzsignals angeglichen wird (optional kann die besagte Angleichung aber auch noch zu anderen Zeitpunkten erfolgen, wie nachfolgend noch erwähnt, also beispielsweise auch beim Umschalten von der Anregung zur Messung).

Vorzugsweise wird das Anregungsreferenzsignal während des Verfahrens kontinuierlich erzeugt.

In anderen Worten kann vorgesehen sein, dass die einzelnen Anregungspulse (und/oder die nachfolgend noch erwähnten Auslesepulse) aus einzelnen Zeitabschnitten eines gemeinsamen, kontinuierlichen Referenzsignals erzeugt werden. Das periodische Signal des Referenzsignals kann somit vorzugsweise kontinuierlich erzeugt und nur zeitweise zur Angleichung der Betriebsphase des Anregungssignals verwendet werden. Somit kann die Phasenkohärenz und - sofern erforderlich bzw. gewünscht - sogar Phasengleichheit aller Anregungspulse und/oder Auslesepulse mit technisch einfachen Mitteln sichergestellt werden.

Die vorgeschlagene Erfindung löst somit das Problem des Verlusts der Phaseninformation bei einem Umschalten des Anregungssignals für das B₁-Magnetfeld zwischen zwei aufeinanderfolgenden Anregungspulsen, indem die Betriebsphase des Anregungssignals zumindest während der Anregungspulse an die Phase eines vorzugsweise durchlaufenden bzw. kontinuierlich betriebenen Anregungsreferenzsignals angeglichen wird.

Auf vorteilhafte Weise kann somit im Rahmen der Erfindung ein phasenkohärenter oder phasengleicher Verlauf der Anregungspulse (und ggf. auch der nachfolgend noch erwähnten Auslesepulse) ermöglicht werden. Unter einem "phasengleichen Verlauf" wird im Rahmen der Erfindung verstanden, dass jeder nachfolgende Anregungs- oder Auslesepuls in einer Phasenlage startet, in der sich der unmittelbar vorhergehende Anregungs- bzw. Auslesepuls zu demselben Zeitpunkt befunden hätte, wenn er nicht unterbrochen worden wäre. Unter einem "phasenkohärenten Verlauf" wird im Rahmen der Erfindung insbesondere verstanden, dass sich jeder nachfolgende Anregungs- oder Auslesepuls in Phasenkohärenz mit vorhergehenden Pulsen befindet, auch unabhängig davon, ob die Phase der Anregungspulse verändert (z. B. gezielt geschaltet) wird.

Durch das vorgeschlagene Verfahren kann der zeitliche Abstand zwischen einzelnen Anregungs- oder Auslesepulsen beliebig gewählt werden, was die Flexibilität des Verfahrens erhöht und beispielsweise dazu verwendet werden kann, die Messgeschwindigkeit erheblich zu steigern. Dadurch, dass die Anregungs- und/oder Auslesepulse phasenkohärent verlaufen, kann die Auswertung des Antwortsignals der Probe vereinfacht und die Messgenauigkeit erhöht sein.

Das Anregungssignal kann grundsätzlich auf beliebige Weise bereitgestellt werden. In einer besonders vorteilhaften Weiterbildung der Erfindung kann allerdings vorgesehen sein, dass das Anregungssignal durch einen primären spannungsgesteuerten Oszillator (Voltage-Controlled Oscillator, VCO) erzeugt wird.

Vorzugsweise handelt es sich bei dem primären spannungsgesteuerten Oszillator um einen auf einem LC-Schwingkreis basierenden spannungsgesteuerten Oszillator. Grundsätzlich kann der Schwingkreis allerdings auf beliebige Weise realisiert werden, wobei sich LC VCOs für die vorgesehene Anwendung in der Regel jedoch besonders gut eignen.

Gemäß einer Weiterbildung der Erfindung kann vorgesehen sein, dass die Betriebsphase des Anregungssignals auch im Rahmen des Umschaltens der Betriebsfrequenz von der Resonanzfrequenz in die Leerlauffrequenz an eine Auslesereferenzphase eines von dem Anregungssignal separaten, vorzugsweise kontinuierlich erzeugten, Auslesereferenzsignals angeglichen wird.

Vorzugsweise unterscheidet sich das Auslesereferenzsignal von dem Anregungsreferenzsignal.

Es kann im Rahmen der Erfindung somit bedarfsweise auch sichergestellt werden, dass bei einem Umschalten des Anregungssignals zwischen zwei aufeinanderfolgenden Leerlaufzeiträumen kein Phasenverlust auftritt, indem die Betriebsphase des Anregungssignals während des Leerlaufzeitraums an die Phase eines vorzugsweise weiteren durchlaufenden bzw. kontinuierlich betriebenen Referenzsignals angeglichen wird.

Es kann vorgesehen sein, dass der zeitliche Abstand zwischen unmittelbar aufeinander folgenden Anregungspulsen (also die Auslesedauer) jeweils identisch ist. Grundsätzlich (weniger bevorzugt) kann allerdings auch vorgesehen sein, dass die Auslesedauer variabel ist.

Gemäß einer Weiterbildung der Erfindung kann vorgesehen sein, dass das Anregungsreferenzsignal durch einen ersten sekundären spannungsgesteuerten Oszillator und/oder das Auslesereferenzsignal durch einen zweiten sekundären spannungsgesteuerten Oszillator erzeugt wird.

Vorzugsweise, jedoch nicht notwendigerweise, kann es sich bei den sekundären spannungsgesteuerten Oszillatoren wiederum um LC-basierte VCOs handeln.

Der primäre spannungsgesteuerte Oszillator kann somit auf besonders vorteilhafte Weise mit dem ersten und/oder zweiten sekundären spannungsgesteuerten Oszillator durch "Injection Locking" zur Angleichung der Betriebsphase an die jeweilige Referenz verbunden sein. Der Prozess des "Injection Locking" spannungsgesteuerter Oszillatoren ist in der Literatur bekannt und kann eine Angleichung der Phasen in äußerst kurzer Zeit (bis zu einigen Pikosekunden) ermöglichen.

Es sei betont, dass die Phase des Anregungsreferenzsignals und/oder des Auslesereferenzsignals bedarfsweisen einstellbar bzw. umschaltbar sein kann.

Um optional Anregungs- und/oder Auslesepulse mit unterschiedlichen Phasen zu ermöglichen, kann in einer Weiterbildung der Erfindung vorgesehen sein, dass der erste sekundäre spannungsgesteuerte Oszillator und/oder der zweite sekundäre spannungsgesteuerte Oszillator als spannungsgesteuerter Mehrphasenoszillator ausgebildet ist.

Zur bedarfsweisen Auswahl aus den verschiedenen, zueinander phasenverschobenen Ausgangssignalen des Mehrphasenoszillators kann vorzugsweise ein Multiplexer verwendet werden.

Insbesondere kann vorgesehen sein, dass der Mehrphasenoszillator zwei, drei, vier, fünf, sechs oder mehr verschiedene, zueinander phasenverschobene Ausgangssignale bereitstellt (bei vier Ausgangssignalen können diese z. B. jeweils um 90° zueinander phasenverschoben sein), aus denen bedarfsweise auswählbar sein kann, um die Betriebsphase des Anregungssignals daran anzugleichen.

In einer Weiterbildung der Erfindung kann vorgesehen sein, dass das Angleichen der Betriebsphase an die Anregungsreferenzphase und/oder an die Auslesereferenzphase durch Injection Locking des primären spannungsgesteuerten Oszillators mit dem ersten sekundären spannungsgesteuerten Oszillator bzw. mit dem zweiten sekundären spannungsgesteuerten Oszillator erfolgt.

Das Angleichen (d. h. Annähern bis vorzugsweise, aber nicht notwendigerweise, zur vollständigen Übereinstimmung) der Betriebsphase an die Referenzphasen muss allerdings nicht unbedingt durch Injection Locking erfolgen, sondern kann im Rahmen der Erfindung auch durch eine alternative technische Umsetzung erfolgen.

In einer vorteilhaften Weiterbildung der Erfindung kann vorgesehen sein, dass der primäre spannungsgesteuerte Oszillator in dem Anregungszeitraum mit einem ersten Eingangssignal zur Erzeugung der Resonanzfrequenz und in dem Leerlaufzeitraum mit einem zweiten Eingangssignal zur Erzeugung der Leerlauffrequenz beaufschlagt wird.

In einer Weiterbildung der Erfindung kann vorgesehen sein, dass zumindest zwei der unmittelbar aufeinander folgenden Anregungszeiträume, vorzugsweise alle Anregungszeiträume, zueinander phasenkohärent verlaufen. Entsprechendes kann für die optionalen Leerlauf- bzw. Auslesezeiträume gelten.

In einer vorteilhaften Weiterbildung der Erfindung kann vorgesehen sein, dass die Resonanzfrequenz gegenüber der Leerlauffrequenz zumindest um den Faktor 2 erhöht ist, vorzugsweise zumindest um den Faktor 1,5 erhöht ist, besonders bevorzugt zumindest um den Faktor 1,05 erhöht ist. Beispielsweise kann eine Bandbreite von zumindest 100 MHz ausreichend sein, um ein ESR-Spektrum abzudecken.

In einer vorteilhaften Weiterbildung der Erfindung kann vorgesehen sein, dass die induktive Baugruppe unterbrechungsfrei von dem Anregungssignal angeregt wird.

Vorzugsweise wird das Anregungssignal somit nicht ein- und ausgeschaltet. Zur Bereitstellung der zeitlich beabstandeten Anregungspulse wird somit vorzugsweise lediglich die Betriebsfrequenz umgeschaltet. Auf diese Weise können lange Einschwingvorgänge der beteiligten Oszillatoren vorteilhaft vermieden werden.

Vorzugsweise wird die induktive Baugruppe während des Leerlaufzeitraums des Anregungssignals als Sensorelement zur Erfassung des elektromagnetischen Antwortsignals der Probe verwendet. Hierfür sind bereits verschiedene Verfahren bekannt, weshalb zum weiteren Hintergrund auf die einschlägige Fachliteratur verwiesen sei. Der Leerlaufzeitraum des Anregungssignals kann daher auch als "Auslesezeitraum" bezeichnet werden. Das Anregungssignal kann in dem Leerlaufzeitraum optional zum Auslesen der Antwortsignale der Probe geeignete "Auslesepulse" bereitstellen.

In einer vorteilhaften Weiterbildung der Erfindung kann also insbesondere vorgesehen sein, dass das Antwortsignal der Probe mittels der induktiven Baugruppe während des Leerlaufzeitraums des Anregungssignals erfasst und von einer Steuereinrichtung ausgewertet wird.

Die Steuereinrichtung kann als Mikroprozessor ausgebildet sein. Anstelle eines Mikroprozessors kann auch eine beliebige weitere Einrichtung zur Implementierung der Steuereinrichtung vorgesehen sein, beispielsweise eine oder mehrere Anordnungen diskreter elektrischer Bauteile auf einer Leiterplatte, eine speicherprogrammierbare Steuerung (SPS), eine anwendungsspezifische integrierte Schaltung (ASIC) oder eine sonstige programmierbare Schaltung, beispielsweise auch ein Field Programmable Gate Array (FPGA), eine programmierbare logische Anordnung (PLA) und/oder ein handelsüblicher Computer.

Vorzugsweise handelt es sich bei der Steuereinrichtung um eine Schaltungskomponente einer integrierten Schaltung.

In einer Weiterbildung der Erfindung kann vorgesehen sein, dass eine Betriebsamplitude des Anregungssignals in dem Leerlaufzeitraum gegenüber dem Anregungszeitraum verringert wird, vorzugsweise zumindest auf 50% verringert wird, besonders bevorzugt zumindest auf 20% verringert wird, weiter bevorzugt zumindest auf 10% verringert wird.

Auf vorteilhafte Weise kann das vorgeschlagene Prinzip erweitert werden, indem die Amplitude der Oszillation bzw. des Anregungssignals zwischen der gepulsten Anregung (d. h. der VCO-Betriebsfrequenz in Resonanz) und der anschließenden Detektion (d. h. der VCO-Betriebsfrequenz außerhalb Resonanz) umgeschaltet wird, um die Anregungseffizienz zu erhöhen bzw. um die Detektionsempfindlichkeit zu optimieren.

Die Erfindung betrifft auch ein Magnetometer zur Messung eines ersten Magnetfeldes durch Erzeugung und/oder Detektion einer Magnetisierung einer Probe an einem Probenort, aufweisend eine induktive Baugruppe und eine Steuereinrichtung die eingerichtet ist, die induktive Baugruppe durch ein Anregungssignal anzuregen, um ein zweites Magnetfeld an dem Probenort bereitzustellen.

Bei dem Magnetometer kann es sich insbesondere um ein kernspinresonanzbasiertes Magnetometer (NMR-Magnetometer) oder um ein elektronenspinresonanzbasiertes Magnetometer (ESR-Magnetometer) handeln.

An dieser Stelle sei erwähnt, dass die Probe und/oder der Probenort nicht unbedingt Bestandteil des Magnetometers sein müssen. Die Probe und/oder der Probenort können auch unabhängig von dem Magnetometer sein. Vorzugsweise können die Probe und/oder der Probenort allerdings eine Komponente des Magnetometers sein. Dies gilt analog auch für die nachfolgend noch genannte Spektroskopievorrichtung.

Der Probenort kann vorzugsweise Mittel zur Befestigung und Aufbewahrung der Probe aufweisen.

Erfindungsgemäß ist für das Magnetometer vorgesehen, dass das Anregungssignal zyklisch zwischen einem Anregungszeitraum, in dem eine Betriebsfrequenz des Anregungssignals eine probenspezifische Resonanzfrequenz aufweist, und einem Leerlaufzeitraum, in dem die Betriebsfrequenz des Anregungssignals eine von der Resonanzfrequenz verschiedene Leerlauffrequenz aufweist, umgeschaltet wird. Zumindest im Rahmen des Umschaltens der Betriebsfrequenz des Anregungssignals von der Leerlauffrequenz in die Resonanzfrequenz wird eine Betriebsphase des Anregungssignals an eine Anregungsreferenzphase eines von dem Anregungssignal separaten, vorzugsweise kontinuierlich erzeugten, Anregungsreferenzsignals angeglichen oder zumindest angenähert.

Durch die vorgeschlagene Anregungstechnik wird nicht nur eine hochgenaue, sondern im Vergleich mit den bekannten Magnetometern auch eine wesentlich schnellere Magnetfeldmessung möglich.

Gemäß einer Weiterbildung der Erfindung kann vorgesehen sein, dass die induktive Baugruppe und die Steuereinrichtung auf einer gemeinsamen integrierten Schaltung angeordnet sind.

Vorzugsweise kann außerdem auch vorgesehen sein, dass der Probenort und/oder die Probe auf der gemeinsamen integrierten Schaltung angeordnet sind. Es kann somit vorzugsweise ein vollständig auf einer integrierten Schaltung basierendes Magnetometer bereitgestellt werden. Auf vorteilhafte Weise kann daher ein chipbasiertes ESR- oder NMR-Magnetometer bereitgestellt werden.

Durch die Integration vorzugsweise der gesamten Elektronik und optional auch des Probenortes und der Probe in bzw. auf einem einzigen miniaturisierten Chip kann der Sensor in einer vorteilhaften Anwendung beispielsweise direkt im Magnetfeld eines MRT-Systems integriert werden und somit erstmalig eine quasi kontinuierliche Magnetfeldmessung bei laufendem Betrieb des MRT-Systems ermöglichen. Durch die Messung des Magnetfeldes des MRT-Systems in Echtzeit können Bewegungsartefakte minimiert, weitaus höherauflösende MRT-Bilder erzeugt und somit die gesamte medizinische Bildgebung verbessert werden. Zusätzlich erhöht eine schnellere Bildgebung nicht nur den Patientenkomfort, sondern auch die Effizienz der Diagnose.

Die Erfindung betrifft daher auch ein MRT-System, aufweisend ein Magnetometer gemäß den vorstehenden und nachfolgenden Ausführungen. Das Magnetometer kann innerhalb des MRT-Systems verwendbar sein, um die Bildgebung zu verbessern, wie vorstehend angegeben.

Die Erfindung betrifft auch eine Spektroskopievorrichtung zur Untersuchung einer Probe an einem Probenort, aufweisend eine Einrichtung zur Erzeugung eines ersten Magnetfeldes an dem Probenort, eine induktive Baugruppe und eine Steuereinrichtung die eingerichtet ist, die induktive Baugruppe durch ein Anregungssignal anzuregen, um ein zweites Magnetfeld an dem Probenort bereitzustellen.

Bei der Spektroskopievorrichtung handelt es sich vorzugsweise um eine ESR-Spektroskopievorrichtung oder um eine NMR-Spektroskopievorrichtung.

Die Einrichtung zur Erzeugung des ersten Magnetfeldes kann insbesondere ausgebildet sein, ein statisches (oder quasi-statisches) erstes Magnetfeld in vorbestimmter Richtung und Stärke an dem Probenort bereitzustellen. Die Einrichtung zur Erzeugung des ersten Magnetfeldes kann zum Beispiel durch supraleitende Magnete oder Elektromagnete beliebiger Ausführung oder durch Permanentmagnete realisierbar sein.

Das erste Magnetfeld ist vorzugsweise statisch und entspricht dem vorstehend bereits erwähnten Magnetfeld B₀, das zur Magnetisierung einer zur Magnetisierung geeigneten Probe dient. Das erste Magnetfeld kann grundsätzlich von beliebiger Stärke sein, solange die Frequenz des anregenden B₁-Magnetfelds ("zweites Magnetfeld") entsprechend den Resonanzbedingungen bzw. der so genannten Larmor-Frequenz der Probe gewählt wird.

Erfindungsgemäß wird das Anregungssignal zyklisch zwischen einem Anregungszeitraum, in dem eine Betriebsfrequenz des Anregungssignals eine probenspezifische Resonanzfrequenz aufweist, und einem Leerlaufzeitraum, in dem die Betriebsfrequenz des Anregungssignals eine von der Resonanzfrequenz verschiedene Leerlauffrequenz aufweist, umgeschaltet. Es ist vorgesehen, dass zumindest im Rahmen des Umschaltens der Betriebsfrequenz des Anregungssignals von der Leerlauffrequenz in die Resonanzfrequenz eine Betriebsphase des Anregungssignals an eine Anregungsreferenzphase eines von dem Anregungssignal separaten, vorzugsweise kontinuierlich erzeugten, Anregungsreferenzsignals angeglichen oder zumindest angenähert wird.

Es kann vorgesehen sein, dass die Spektroskopievorrichtung eine Auswerteschaltung zur Verarbeitung einer Ausgangspannung der induktiven Baugruppe aufweist, wobei die Auswerteschaltung vorzugsweise Mittel zur Demodulation, Analog-Digital-Umsetzung und/oder Mittel zur digitalen Datenverarbeitung aufweist. Entsprechende Auswerteschaltungen, die sich zur Auswertung des Ausgangssignals der Probe eignen können, sind grundsätzlich bekannt.

Es kann vorgesehen sein, dass die Auswerteschaltung eingerichtet ist, die Magnetisierung der Probe und die daraus zu ermittelnde Spinkonzentration einzelner Spektralkomponenten zu bestimmen.

Erfindungsgemäß kann eine besonders schnelle und hochpräzise Magnetfeldmessung für beispielsweise ESR-Anwendungen bereitgestellt werden. Eine mögliche weitere vorteilhafte Anwendung des erfindungsgemäßen Verfahrens betrifft die Medizintechnik (beispielsweise MRT-Systeme), wie vorstehend bereits erwähnt.

Merkmale, die im Zusammenhang mit einem der Gegenstände der Erfindung, namentlich gegeben durch das erfindungsgemäße Verfahren, das erfindungsgemäße Magnetometer, das erfindungsgemäße MRT-System und die erfindungsgemäße Spektroskopievorrichtung beschrieben wurden, sind auch für die anderen Gegenstände der Erfindung vorteilhaft umsetzbar. Ebenso können Vorteile, die im Zusammenhang mit einem der Gegenstände der Erfindung genannt wurden, auch auf die anderen Gegenstände der Erfindung bezogen verstanden werden.

An dieser Stelle sei darauf hingewiesen, dass der in der vorliegenden Beschreibung und in den Patentansprüchen verwendete Begriff "verbunden" bzw. "Verbindung" eine unmittelbare elektrische Verbindung der genannten Komponenten, aber auch eine mittelbare elektrische Verbindung der genannten Komponenten (also z. B. über weitere elektrische Leitungen oder elektronische Bauteile wie Widerstände, Induktivitäten und/oder Kapazitäten etc.) beschreiben kann.

Der Begriffe "angeschlossen" oder "kontaktiert" deutet hingegen in der Regel eine unmittelbare Verbindung der genannten Komponenten an.

Es sei außerdem betont, dass Verfahrensschritte nicht unbedingt in der Reihenfolge durchgeführt werden müssen, in der sie in der Beschreibung oder in den Patentansprüchen erstmals beschrieben oder erwähnt sind. Es können daher beispielsweise einzelne Verfahrensschritte oder Gruppen von Verfahrensschritten untereinander austauschbar sein, wenn dies technisch nicht ausgeschlossen ist. Auch können Verfahrensschritte miteinander kombiniert, in separate Zwischenschritte aufgeteilt oder mit Zwischenschritten ergänzt werden. Das erfindungsgemäße Verfahren ist mit den beschriebenen Verfahrensschritten auch nicht unbedingt abschließend beschrieben und kann mit weiteren, auch nicht genannten Verfahrensschritten, erweitert werden.

Ergänzend sei darauf hingewiesen, dass Begriffe wie "umfassend", "aufweisend" oder "mit" keine anderen Merkmale oder Schritte ausschließen. Ferner schließen Begriffe wie "ein" oder "das", die auf eine Einzahl von Schritten oder Merkmalen hinweisen, keine Mehrzahl von Merkmalen oder Schritten aus - und umgekehrt.

In einer puristischen Ausführungsform der Erfindung kann allerdings auch vorgesehen sein, dass die in der Erfindung mit den Begriffen "umfassend", "aufweisend" oder "mit" eingeführten Merkmale abschließend aufgezählt sind. Dementsprechend kann eine oder können mehrere Aufzählungen von Merkmalen im Rahmen der Erfindung als abgeschlossen betrachtet werden, beispielsweise jeweils für jeden Anspruch betrachtet. Die Erfindung kann beispielsweise ausschließlich aus den in Anspruch 1 genannten Merkmalen bestehen.

Es sei erwähnt, dass Bezeichnungen wie "erstes" oder "zweites" etc. vornehmlich aus Gründen der Unterscheidbarkeit von jeweiligen Vorrichtungs- oder Verfahrensmerkmalen verwendet werden und nicht unbedingt andeuten sollen, dass sich Merkmale gegenseitig bedingen oder miteinander in Beziehung stehen.

Ferner sei betont, dass die vorliegend beschriebenen Werte und Parameter Abweichungen oder Schwankungen von ±10% oder weniger, vorzugsweise ±5% oder weniger, weiter bevorzugt ±1% oder weniger, und ganz besonders bevorzugt ±0,1% oder weniger des jeweils benannten Wertes bzw. Parameters mit einschließen, sofern diese Abweichungen bei der Umsetzung der Erfindung in der Praxis nicht ausgeschlossen sind. Die Angabe von Bereichen durch Anfangs- und Endwerte umfasst auch all diejenigen Werte und Bruchteile, die von dem jeweils benannten Bereich eingeschlossen sind, insbesondere die Anfangs- und Endwerte und einen jeweiligen Mittelwert.

Nachfolgend werden Ausführungsbeispiele der Erfindung anhand der Zeichnungen näher beschrieben.

Die Figuren zeigen jeweils bevorzugte Ausführungsbeispiele, in denen einzelne Merkmale der vorliegenden Erfindung in Kombination miteinander dargestellt sind. Merkmale eines Ausführungsbeispiels sind auch losgelöst von den anderen Merkmalen des gleichen Ausführungsbeispiels umsetzbar und können dementsprechend von einem Fachmann ohne Weiteres zu weiteren sinnvollen Kombinationen und Unterkombinationen mit Merkmalen anderer Ausführungsbeispiele verbunden werden.

In den Figuren sind funktionsgleiche Elemente mit denselben Bezugszeichen versehen.

Es zeigen schematisch:
- Figur 1: ein Magnetometer und eine Spektroskopievorrichtung gemäß einem Ausführungsbeispiel der Erfindung;
- Figur 2: ein beispielhaftes Anregungssignal für das Magnetometer oder die Spektroskopievorrichtung gemäß Figur 1;
- Figur 3: eine beispielhafte Implementierung des erfindungsgemäßen Verfahrens;
- Figur 4: eine weitere beispielhafte Implementierung des erfindungsgemäßen Verfahrens;
- Figur 5: eine weitere beispielhafte Implementierung des erfindungsgemäßen Verfahrens;
- Figur 6: Simulationsergebnisse des vorgeschlagenen Verfahrens zur Verdeutlichung des Prinzips des Angleichens der Betriebsphase des Anregungssignals an das Anregungsreferenzsignal durch Injection Locking;
- Figur 7: Simulationsergebnisse des vorgeschlagenen Verfahrens zur Darstellung eines detektierten ESR-Signals nach einem Anregungspuls; und
- Figur 8: eine weitere beispielhafte Implementierung des erfindungsgemäßen Verfahrens.

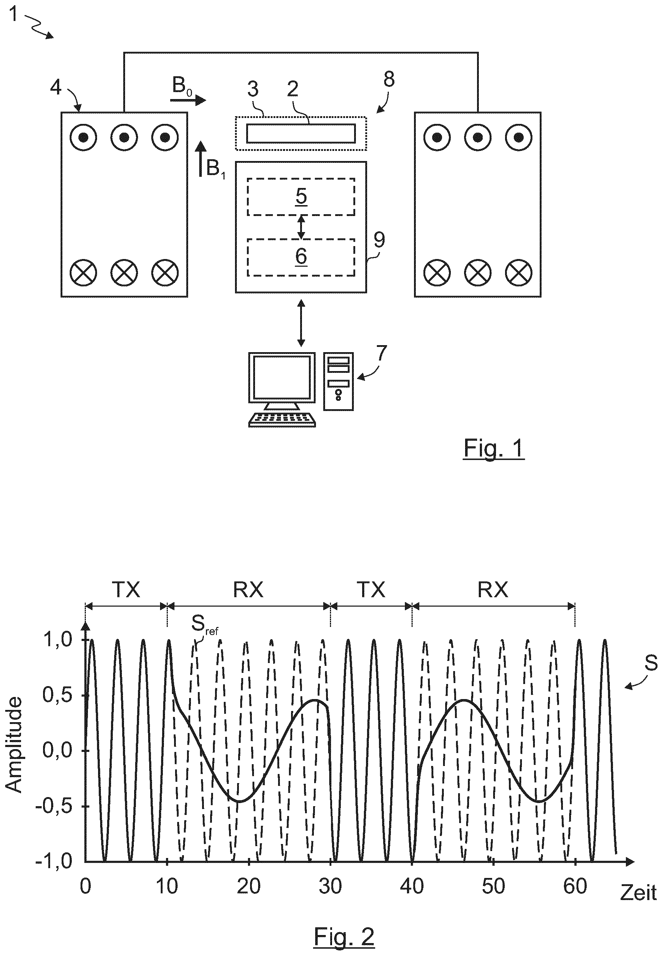

In Figur 1 ist beispielhaft eine Spektroskopievorrichtung 1 zur Untersuchung einer Probe 2 an einem Probenort 3 dargestellt, wie diese im Rahmen einer Elektronenspinresonanz-Spektroskopie oder Kernspinresonanz-Spektroskopie gemäß der vorliegenden Erfindung zum Einsatz kommen kann. Da das grundsätzliche Prinzip einer ESR- oder NMR- Spektroskopievorrichtung bekannt ist, wird dieses nachfolgend nur auf grundlegende Weise beschrieben. Für weitere Details sei auf die einschlägige Literatur verwiesen.

Die Spektroskopievorrichtung 1 weist eine Einrichtung 4 zur Erzeugung bzw. Bereitstellung eines (vorzugsweise statischen) ersten Magnetfelds B₀ an dem Probenort 3 auf. Die Einrichtung 4 kann beispielsweise als Magnet, zum Beispiel supraleitender Magnet (z. B. ein 9,4 T-Magnet), Elektromagnet beliebiger Ausführung, Permanentmagnet oder interner, probenintrinsischer Magnet (z. B. Dipolfelder) ausgebildet sein. Das erste Magnetfeld B₀ induziert in der Probe 2 eine Magnetisierung entsprechend der Suszeptibilität der Probe 2.

Die Spektroskopievorrichtung 1 weist außerdem eine induktive Baugruppe 5 auf, sowie eine Steuereinrichtung 6, um die induktive Baugruppe 5 durch ein Anregungssignal S anzuregen, um ein zusätzliches, zweites Magnetfeld B₁ an dem Probenort 3 bereitzustellen. Die Steuereinrichtung 6 ist eingerichtet, mittels der induktiven Baugruppe 5 das zweite Magnetfeld B₁ derart zu erzeugen, dass die Magnetisierung der Probe 2 aus ihrer Gleichgewichtslage ausgelenkt wird. Das zweite Magnetfeld B₁ ist insbesondere bei der konventionellen, transversalen ESR orthogonal zu dem ersten Magnetfeld B₀ orientiert bzw. weist zumindest eine zu dem ersten Magnetfeld B₀ orthogonale Komponente auf (es sei aber erwähnt, dass im Rahmen der Erfindung auch longitudinale ESR-Verfahren zur Anwendung kommen können). Die induktive Baugruppe 5 und die Steuereinrichtung 6 sind in Figur 1 jeweils nur schematisch als Black-Box angedeutet.

Um die Magnetisierung der Probe 2 anschließend auch zu detektieren, kann ein über die induktive Baugruppe 5 erfasstes Antwortsignal der Probe 2 an eine Auswerteschaltung 7 übergeben werden. Die Auswerteschaltung 7 kann vorzugsweise Mittel zur Demodulation, Analog-Digital-Umsetzung und/oder Mittel zur digitalen Datenverarbeitung aufweisen und ist in Figur 1 lediglich beispielhaft angedeutet. Die Auswerteschaltung 7 kann eingerichtet sein, die Magnetisierung der Probe 2 und die daraus zu ermittelte Spinkonzentration einzelner Spektralkomponenten zu bestimmen. Es kann vorgesehen sein, dass die Auswerteschaltung 7 Teil der Steuereinrichtung 6 ist - oder umgekehrt.

Die Erfindung kann sich aber auch zur Verwendung in einem Magnetometer 8 bzw. als Magnetometer 8 zur Messung des ersten Magnetfelds B₀ vorteilhaft eignen. Wenn also beispielsweise ein äußeres, erstes Magnetfeld B₀ messtechnisch zu untersuchen ist, kann mittels des erfindungsgemäßen Magnetometers 8 das zweite Magnetfeld B₁ über die mittels des Anregungssignals S angeregte induktive Baugruppe 5 erzeugt und das erste Magnetfeld B₀ bei bekannten Materialeigenschaften der Probe 2 bestimmt werden.

Vorzugsweise können alle elektronischen Komponenten und/oder der Probenort 3 und/oder die Probe 2 auf einer gemeinsamen integrierten Schaltung 9 angeordnet sein. Ein entsprechendes Magnetometer 8 kann sich beispielsweise vorteilhaft zur Bildkorrektur innerhalb eines MRT-Systems (nicht dargestellt) eignen.

Es wird also ein Verfahren zur Erzeugung und/oder Detektion einer Magnetisierung der Probe 2 an dem Probenort 3 vorgeschlagen, insbesondere für die Untersuchung der Probe 2 mittels ESR-Spektroskopie oder NMR-Spektroskopie oder für die Messung eines auf die Probe 2 an dem Probenort 3 einwirkenden, ersten Magnetfeldes B₀.

Im Rahmen der Erfindung ist vorgesehen, dass das Anregungssignal S zyklisch zwischen einem Anregungszeitraum TX, in dem eine Betriebsfrequenz f_{ESR} des Anregungssignals S eine probenspezifische Resonanzfrequenz fᵣₑₛ aufweist, und einem Leerlaufzeitraum RX, in dem die Betriebsfrequenz f_{ESR} des Anregungssignals S eine von der Resonanzfrequenz fᵣₑₛ verschiedene Leerlauffrequenz f_{idle} aufweist, umgeschaltet wird.

Ein beispielhaftes Anregungssignal S für das vorgeschlagene Magnetometer 8 oder für die vorgeschlagene Spektroskopievorrichtung 1 ist in Figur 2 angedeutet. Es kann vorgesehen sein, dass die induktive Baugruppe 5 unterbrechungsfrei (oder zumindest im Wesentlichen unterbrechungsfrei) von dem Anregungssignal S angeregt wird. In dem Leerlaufzeitraum RX kann die Betriebsfrequenz f_{ESR} des Anregungssignals S allerdings gegenüber der Resonanzfrequenz fᵣₑₛ verringert sein, vorzugsweise zumindest um den Faktor 2. Auch die Amplitude ("Betriebsamplitude") des Anregungssignals S kann optional in dem Leerlaufzeitraum RX verringert sein, vorzugsweise (aber nicht notwendigerweise) zumindest um den Faktor 2, was ebenfalls schematisch in Figur 2 angedeutet ist.

Im Rahmen der Erfindung ist weiter vorgesehen, dass eine Betriebsphase des Anregungssignals S zumindest im Rahmen des Umschaltens der Betriebsfrequenz f_{ESR} von der Leerlauffrequenz f_{idle} in die Resonanzfrequenz fᵣₑₛ an eine Anregungsreferenzphase eines von dem Anregungssignal S separaten, vorzugsweise kontinuierlich erzeugten, Anregungsreferenzsignals S_{ref} angeglichen wird. Auf diese Weise kann vorzugsweise sichergestellt werden, dass zumindest zwei unmittelbar aufeinander folgende Anregungszeiträume TX, vorzugsweise alle Anregungszeiträume TX, zueinander phasenkohärent verlaufen. Zur Verdeutlichung ist in Figur 2 das Anregungsreferenzsignal S_{ref} durchlaufend strichliniert angedeutet.

Dadurch, dass im Rahmen der Erfindung der Verlust der Phaseninformation bei einem Umschalten des Anregungssignals S zwischen zwei aufeinanderfolgenden Anregungspulsen vermieden wird, kann die Auswertung des Antwortsignals der Probe 2 vereinfacht und die Messgenauigkeit erhöht sein (manche Messungen können hierdurch überhaupt erst ermöglich werden). Durch die Verwendung des Anregungsreferenzsignals S_{ref} kann die Angleichung der Betriebsphase des Anregungssignals S unmittelbar nach dem Umschaltzeitpunkt besonders einfach und schnell erfolgen, wodurch der zeitliche Abstand zwischen einzelnen Anregungs- oder Auslesepulsen verringert und damit die Messgeschwindigkeit des Verfahrens gegenüber dem Stand der Technik erheblich erhöht werden kann.

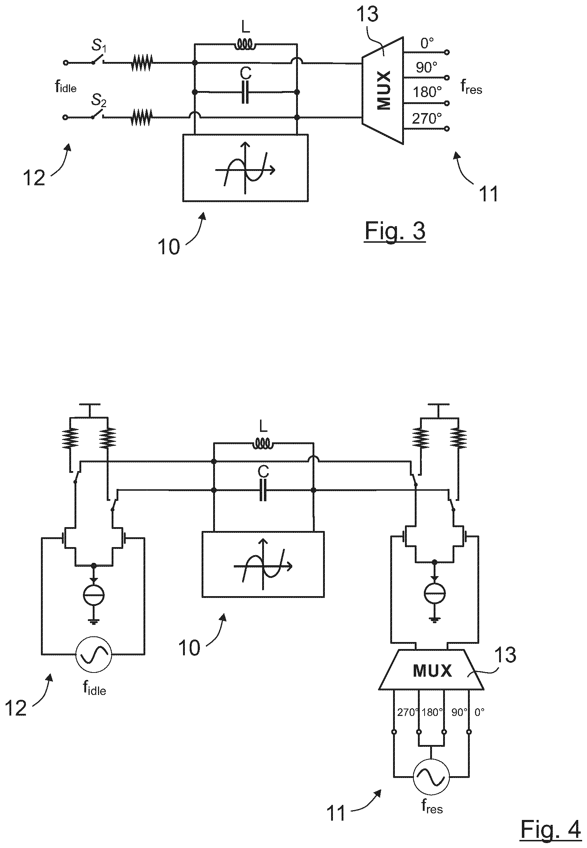

Figur 3 zeigt schematisch eine mögliche Umsetzung des vorgeschlagenen Verfahrens, wobei eine beispielhafte, weiter konkretisierte Implementierung in Figur 4 angedeutet ist.

Das Anregungssignal S zur Erzeugung des zweiten Magnetfeldes B₁ kann vorzugsweise durch einen primären spannungsgesteuerten Oszillator 10 erzeugt werden, insbesondere durch einen auf einem LC-Schwingkreis basierenden spannungsgesteuerten Oszillator 10. Das Anregungsreferenzsignal S_{ref} kann durch einen ersten sekundären spannungsgesteuerten Oszillator 11 erzeugt werden, der in den Ausführungsbeispielen als Mehrphasenoszillator ausgebildet ist. Zur bedarfsweisen Auswahl aus vier verschiedenen, jeweils um 90° zueinander phasenverschobenen Ausgangssignalen des ersten sekundären spannungsgesteuerten Mehrphasenoszillators 11 kann ein Multiplexer 13 verwendet werden. Das Angleichen der Betriebsphase an die Anregungsreferenzphase erfolgt vorzugsweise durch Injection Locking des primären spannungsgesteuerten Oszillators 10 mit dem ersten sekundären spannungsgesteuerten Oszillator 11.

Der primäre spannungsgesteuerte Oszillator 10 kann zum Umschalten der Betriebsfrequenz f_{ESR} wahlweise mit einem ersten Eingangssignal zur Erzeugung der Resonanzfrequenz und während des Leerlaufzeitraums mit einem zweiten Eingangssignal zur Erzeugung der Leerlauffrequenz beaufschlagt werden. Das jeweilige Eingangssignal des primären spannungsgesteuerten Oszillators 10, das auf bekannte Weise an dessen eingangsseitige Varaktordiode angelegt werden kann, kann so gewählt werden, dass die vorgesehene Ausgangs- bzw. Zielfrequenz zumindest so weit an die jeweilige Referenzfrequenz der Referenzoszillatoren 11 oder 12 angepasst ist, dass die Frequenzdifferenz für das Injection Locking ausreichend klein ist. Die finale Synchronisierung, insbesondere die Phasenanpassung und ggf. eine Feinjustierung der Ausgangsfrequenz des primären spannungsgesteuerten Oszillators 10, kann anschließend durch das Injection Locking erfolgen.

Wie in den Ausführungsbeispielen dargestellt, kann außerdem vorgesehen sein, dass die Betriebsphase des Anregungssignals S auch im Rahmen des Umschaltens der Betriebsfrequenz f_{ESR} von der Resonanzfrequenz fᵣₑₛ in die Leerlauffrequenz f_{idle} an eine Referenzphase angeglichen wird. Hierfür kann eine Auslesereferenzphase eines von dem Anregungssignal S und dem Anregungsreferenzsignal S_{ref} separaten, vorzugsweise kontinuierlich erzeugten, Auslesereferenzsignals vorgesehen sein. Das Auslesereferenzsignal kann durch einen zweiten sekundären spannungsgesteuerten Oszillator 12 erzeugt werden. Zum Angleichen der Betriebsphase kann hierfür Injection Locking des primären spannungsgesteuerten Oszillators 10 mit dem zweiten sekundären spannungsgesteuerten Oszillator 12 vorgesehen sein. Es sei erwähnt, dass optional vorgesehen sein kann, dass die Auslesereferenzphase wiederum von der Anregungsreferenzphase abgeleitet wird.

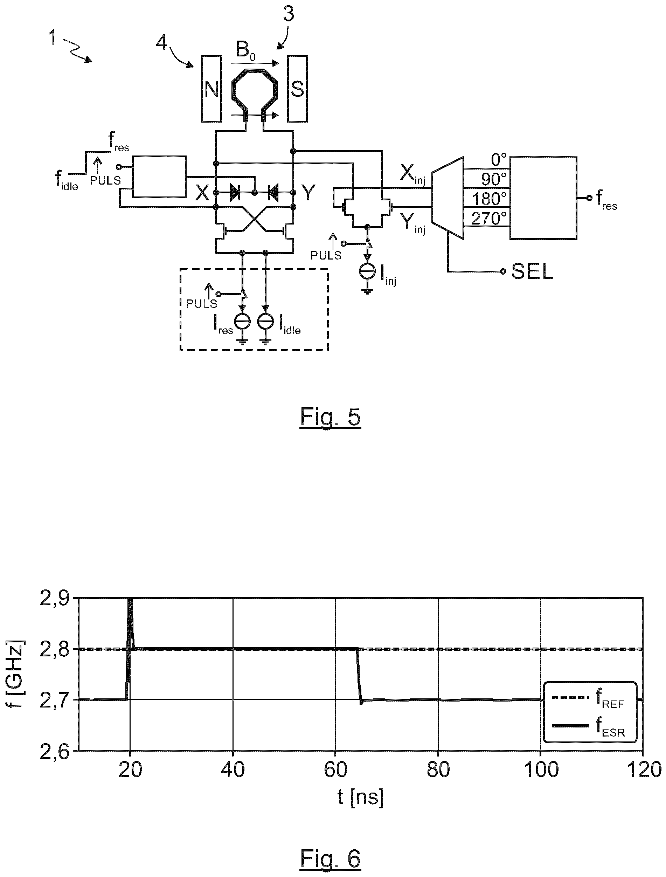

Wie vorstehend bereits erwähnt, kann im Rahmen der Erfindung auch vorgesehen sein, die Amplitude des zweiten Magnetfeldes B₁ in dem Anregungszeitraum TX gegenüber dem Auslese- bzw. Leerlaufzeitraum RXzu erhöhen. Eine beispielhafte diesbezügliche Implementierung ist in Figur 5 angedeutet. Dabei wird der Vorspannungsstrom des primären spannungsgesteuerten Oszillators 10 während der Anregung geändert. Auf diese Weise kann eine verbesserte Spin-Anregung und Effizienz ermöglicht werden, bei gleichzeitig optimaler Nachweisempfindlichkeit unter Verwendung eines kleinen Vorspannungsstroms während dem Leerlauf- bzw. Auslesezeitraum.

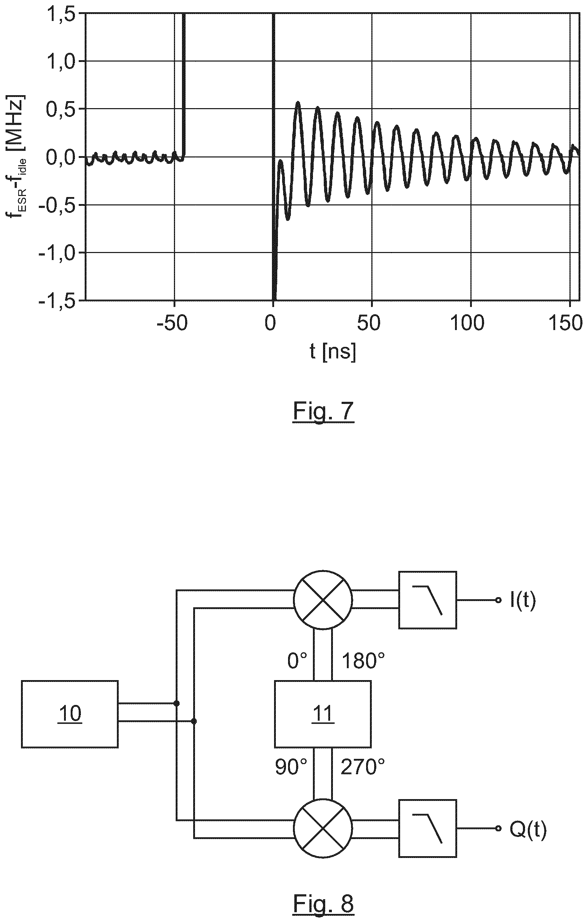

Die Figuren 6 und 7 zeigen beispielhafte Simulationsergebnisse des vorgeschlagenen Verfahrens. Anhand von Figur 6 ist gut erkennbar, wie die Betriebsfrequenz f_{ESR} des primären spannungsgesteuerten Oszillators 10 innerhalb weniger Nanosekunden an die Anregungsreferenzphase des Hilfsoszillators bzw. des ersten sekundären spannungsgesteuerten Oszillators 11 angepasst wird. Ein beispielhaftes ESR-Antwortsignal der Probe nach einem Anregungspuls ist beispielhaft in Figur 7 dargestellt.

Abschließend zeigt Figur 8 noch eine beispielhafte Implementierung zur Abwärtskonvertierung des Ausgangssignals des ESR-Oszillators bzw. des primären spannungsgesteuerten Oszillators 10 unter Verwendung des Referenzoszillators für eine phasenkohärente Detektion.

## Patentansprüche

1. Verfahren zur Erzeugung und/oder Detektion einer Magnetisierung einer Probe (2) an einem Probenort (3), insbesondere für die Untersuchung der Probe (2) mittels Elektronenspinresonanz-Spektroskopie oder für die Messung eines auf die Probe (2) an dem Probenort (3) einwirkenden ersten Magnetfeldes (B₀), wobei eine induktive Baugruppe (5) durch ein Anregungssignal (S) angeregt wird, um ein zweites Magnetfeld (B₁) an dem Probenort (3) bereitzustellen, wobei das Anregungssignal (S) zyklisch zwischen einem Anregungszeitraum (TX), in dem eine Betriebsfrequenz (f_{ESR}) des Anregungssignals (S) eine probenspezifische Resonanzfrequenz (fᵣₑₛ) aufweist, und einem Leerlaufzeitraum (RX), in dem die Betriebsfrequenz (f_{ESR}) des Anregungssignals (S) eine von der Resonanzfrequenz (fᵣₑₛ) verschiedene Leerlauffrequenz (f_{idle}) aufweist, umgeschaltet wird, **dadurch gekennzeichnet, dass**
eine Betriebsphase des Anregungssignals (S) zumindest im Rahmen des Umschaltens der Betriebsfrequenz (f_{ESR}) von der Leerlauffrequenz (f_{idle}) in die Resonanzfrequenz (fᵣₑₛ) an eine Anregungsreferenzphase eines von dem Anregungssignal (S) separaten, vorzugsweise kontinuierlich erzeugten, Anregungsreferenzsignals (S_{ref}) angeglichen wird.

2. Verfahren nach Anspruch 1,
**dadurch gekennzeichnet, dass**
das Anregungssignal (S) durch einen primären spannungsgesteuerten Oszillator (10) erzeugt wird, vorzugsweise durch einen auf einem LC-Schwingkreis basierenden spannungsgesteuerten Oszillator (10).

3. Verfahren nach Anspruch 1 oder 2,
**dadurch gekennzeichnet, dass**
die Betriebsphase des Anregungssignals (S) im Rahmen des Umschaltens der Betriebsfrequenz (f_{ESR}) von der Resonanzfrequenz (fᵣₑₛ) in die Leerlauffrequenz (f_{idle}) an eine Auslesereferenzphase eines von dem Anregungssignal (S) und dem Anregungsreferenzsignal (S_{ref}) separaten, vorzugsweise kontinuierlich erzeugten, Auslesereferenzsignals angeglichen wird.

4. Verfahren nach einem der Ansprüche 1 bis 3,
**dadurch gekennzeichnet, dass**
das Anregungsreferenzsignal (S_{ref}) durch einen ersten sekundären spannungsgesteuerten Oszillator (11) und/oder das Auslesereferenzsignal durch einen zweiten sekundären spannungsgesteuerten Oszillator (12) erzeugt wird.

5. Verfahren nach Anspruch 4,
**dadurch gekennzeichnet, dass**
der erste sekundäre spannungsgesteuerte Oszillator (11) und/oder der zweite sekundäre spannungsgesteuerte Oszillator (12) als spannungsgesteuerter Mehrphasenoszillator ausgebildet ist, wobei vorzugsweise ein Multiplexer (13) zur bedarfsweisen Auswahl aus vier verschiedenen, jeweils um 90° zueinander phasenverschobenen Ausgangssignalen des Mehrphasenoszillators verwendet wird.

6. Verfahren nach Anspruch 4 oder 5,
**dadurch gekennzeichnet, dass**
das Angleichen der Betriebsphase an die Anregungsreferenzphase und/oder an die Auslesereferenzphase durch Injection Locking des primären spannungsgesteuerten Oszillators (10) mit dem ersten sekundären spannungsgesteuerten Oszillator (11) bzw. mit dem zweiten sekundären spannungsgesteuerten Oszillator (12) erfolgt.

7. Verfahren nach einem der Ansprüche 2 bis 6,
**dadurch gekennzeichnet, dass**
der primäre spannungsgesteuerte Oszillator (10) in dem Anregungszeitraum (TX) mit einem ersten Eingangssignal zur Erzeugung der Resonanzfrequenz (fᵣₑₛ) und in dem Leerlaufzeitraum (RX) mit einem zweiten Eingangssignal zur Erzeugung der Leerlauffrequenz (f_{idle}) beaufschlagt wird.

8. Verfahren nach einem der Ansprüche 1 bis 7,
**dadurch gekennzeichnet, dass**
zumindest zwei der unmittelbar aufeinander folgenden Anregungszeiträume (TX), vorzugsweise alle der Anregungszeiträume (TX), zueinander phasenkohärent verlaufen.

9. Verfahren nach einem der Ansprüche 1 bis 8,
**dadurch gekennzeichnet, dass**
die Resonanzfrequenz (fᵣₑₛ) gegenüber der Leerlauffrequenz (f_{idle}) zumindest um den Faktor 2 erhöht ist, vorzugsweise zumindest um den Faktor 1,5 erhöht ist, besonders bevorzugt zumindest um den Faktor 1,05 erhöht ist.

10. Verfahren nach einem der Ansprüche 1 bis 9,
**dadurch gekennzeichnet, dass**
die induktive Baugruppe (5) unterbrechungsfrei von dem Anregungssignal (S) angeregt wird.

11. Verfahren nach einem der Ansprüche 1 bis 10,
**dadurch gekennzeichnet, dass**
ein Antwortsignal der Probe (2) mittels der induktiven Baugruppe (5) während dem Leerlaufzeitraum (RX) des Anregungssignals (S) erfasst und von einer Steuereinrichtung (6) ausgewertet wird.

12. Verfahren nach einem der Ansprüche 1 bis 11,
**dadurch gekennzeichnet, dass**
eine Betriebsamplitude des Anregungssignals (S) in dem Leerlaufzeitraum (RX) gegenüber dem Anregungszeitraum (TX) verringert wird, vorzugsweise zumindest auf 50% verringert wird, besonders bevorzugt zumindest auf 20% verringert wird, weiter bevorzugt zumindest auf 10% verringert wird.

13. Magnetometer (8) zur Messung eines ersten Magnetfeldes (B₀) durch Erzeugung und/oder Detektion einer Magnetisierung einer Probe (2) an einem Probenort (3), insbesondere kernspinresonanzbasiertes Magnetometer (8) oder elektronenspinresonanzbasiertes Magnetometer (8), aufweisend eine induktive Baugruppe (5) und eine Steuereinrichtung (6) die eingerichtet ist, die induktive Baugruppe (5) durch ein Anregungssignal (S) anzuregen, um ein zweites Magnetfeld (B₁) an dem Probenort (3) bereitzustellen, wobei das Anregungssignal (S) zyklisch zwischen einem Anregungszeitraum (TX), in dem eine Betriebsfrequenz (f_{ESR}) des Anregungssignals (S) eine probenspezifische Resonanzfrequenz (fᵣₑₛ) aufweist, und einem Leerlaufzeitraum (RX), in dem die Betriebsfrequenz (f_{ESR}) des Anregungssignals (S) eine von der Resonanzfrequenz (fᵣₑₛ) verschiedene Leerlauffrequenz (f_{idle}) aufweist, umgeschaltet wird,
**dadurch gekennzeichnet, dass**
zumindest im Rahmen des Umschaltens der Betriebsfrequenz (f_{ESR}) des Anregungssignals (S) von der Leerlauffrequenz (f_{idle}) in die Resonanzfrequenz (fᵣₑₛ) eine Betriebsphase des Anregungssignals (S) an eine Anregungsreferenzphase eines von dem Anregungssignal (S) separaten, vorzugsweise kontinuierlich erzeugten, Anregungsreferenzsignals (S_{ref}) angeglichen oder zumindest angenähert wird.

14. Magnetometer (8) nach Anspruch 13,
**dadurch gekennzeichnet, dass**
die induktive Baugruppe (5) und die Steuereinrichtung (6) auf einer gemeinsamen integrierten Schaltung (9) angeordnet sind.

15. Spektroskopievorrichtung (1) zur Untersuchung einer Probe (2) an einem Probenort (3), insbesondere Elektronenspinresonanz-Spektroskopievorrichtung oder Kernspinresonanz-Spektroskopievorrichtung, aufweisend eine Einrichtung (4) zur Erzeugung eines ersten Magnetfeldes (B₀) an dem Probenort (3), eine induktive Baugruppe (5) und eine Steuereinrichtung (6) die eingerichtet ist, die induktive Baugruppe (5) durch ein Anregungssignal (S) anzuregen, um ein zweites Magnetfeld (B₁) an dem Probenort (3) bereitzustellen, wobei das Anregungssignal (S) zyklisch zwischen einem Anregungszeitraum (TX), in dem eine Betriebsfrequenz (f_{ESR}) des Anregungssignals (S) eine probenspezifische Resonanzfrequenz (fᵣₑₛ) aufweist, und einem Leerlaufzeitraum (RX), in dem die Betriebsfrequenz (f_{ESR}) des Anregungssignals (S) eine von der Resonanzfrequenz (fᵣₑₛ) verschiedene Leerlauffrequenz (f_{idle}) aufweist, umgeschaltet wird,
**dadurch gekennzeichnet, dass**
zumindest im Rahmen des Umschaltens der Betriebsfrequenz (f_{ESR}) des Anregungssignals (S) von der Leerlauffrequenz (f_{idle}) in die Resonanzfrequenz (fᵣₑₛ) eine Betriebsphase des Anregungssignals (S) an eine Anregungsreferenzphase eines von dem Anregungssignal (S) separaten, vorzugsweise kontinuierlich erzeugten, Anregungsreferenzsignals (S_{ref}) angeglichen oder zumindest angenähert wird.
